Europäisches Patentamt

European Patent Office

Office européen des brevets

(19)

(11) Veröffentlichungsnummer: **0 338 267**
**A2**

(12) # EUROPÄISCHE PATENTANMELDUNG

(21) Anmeldenummer: **89105016.3**

(22) Anmeldetag: **21.03.89**

(51) Int. Cl.⁴: **H05K 7/14 , H02P 6/02**

(30) Priorität: **19.04.88 DE 3813063**

(43) Veröffentlichungstag der Anmeldung:
**25.10.89 Patentblatt 89/43**

(84) Benannte Vertragsstaaten:
**CH DE ES FR GB IT LI NL SE**

(71) Anmelder: **Heidolph-Elektro GmbH & Co. KG**
**Starenstrasse 23**
**D-8420 Kelheim/Donau(DE)**

(72) Erfinder: **Riehl, Günther**
**am Kohlenschacht 22 b**
**D-8403 Bad Abbach(DE)**
Erfinder: **Weissenberger, Wolfgang**
**Asamstrasse 16**
**D-8428 Rohr(DE)**

(74) Vertreter: **Göbel, Matthias, Dipl.-Ing.**
**Pruppacher Hauptstrasse 5-7**
**D-8501 Pyrbaum-Pruppach(DE)**

(54) Gleichstrommotor.

(57) Bei einem Gleichstrommotor mit elektronischer Kommutierung zum Betrieb mit Wechselstrom und einer Ansteuerlogik, ist zu baulichen Vereinfachungen und Nutzung höherer Betriebsspannungen vorgesehen, daß ein Netzteil (2), eine Endstufe (3) und eine Ansteuerlogik (4) ausgelegt für 110 bis 240 Volt Wechselstrom vorgesehen sind und daß der Netzteil (2), die Endstufe (3) und die Ansteuerlogik (4) gemeinsam auf einer einzigen Leiterplatte (1) angeordnet sind.

EP 0 338 267 A2

# Gleichstrommotor

Die Erfindung betrifft einen Gleichstrommotor mit elektronischer Kommutierung zum Betrieb mit Wechselstrom und einer Ansteuerlogik.

Es ist bereits bekannt, bei mit Kleinspannung (24 V bis 60 V) betreibbaren Elektromotoren und Gleichstromanschluß die Ansteuerlogik und die Endstufe auf einer gemeinsamen Leiterplatte anzuordnen und den Netzteil für diese Elektromotoren unabhängig getrennt der Leiterplatte zuzuordnen. Die getrennte Zuordnung des Netzteils wirkt sich bei diesen Motoren ungünstig auf die Ausgestaltung des Motors aus und führt zu unsicheren Handhabungen desselben.

Es ist Aufgabe der Erfindung, Elektromotoren dieser Art im Aufbau zu vereinfachen und Maßnahmen zur Nutzung höherer Betriebsspannungen zu schaffen.

Der Erfindung gemäß ist hierzu vorgesehen, daß ein Netzteil, eine Endstufe und eine Ansteuerlogik ausgelegt für 110 bis 240 Volt Wechselspannung vorgesehen sind und daß der Netzteil, die Endstufe und die Ansteuerlogik gemeinsam auf einer einzigen Leiterplatte angeordnet sind. Auf diese Weise ist der gesamte Schaltungsaufbau auf einem einzigen Bauteil ausgebildet und damit günstige Voraussetzungen zu Aufbauvereinfachungen und zur Anwendung höherer Betriebsspannungen gegeben. Nach bevorzugter Ausbildung ist die Leiterplatte mit einer maximalen Größe von 160 x 100 mm ausgelegt (Europaplatte). Außerdem ist vorgesehen, daß die Wechselspannung eine Frequenz von 47 bis 63 Hz aufweist und schließlich sieht die Erfindung noch vor, in der Endstufe ausschließlich N-Kanal MOS-FET Transistoren für 500 V anzuordnen.

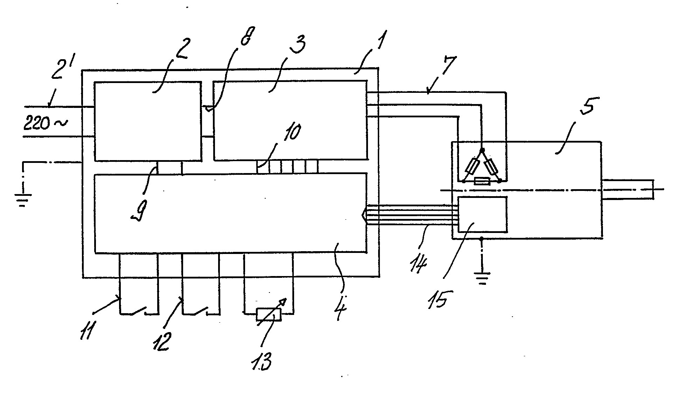

Die Erfindung ist anhand eines Ausführungsbeispiels in der Zeichnung verdeutlicht.

Mit 1 ist eine Leiterplatte bezeichnet, die die Größe von 160 x 100 mm (Europaplatte) aufweist. Auf der Leiterplatte ist ein Netzteil 2 mit Netzanschlußleiter 2' eine Endstufe 3 und eine Ansteuerlogik 4 für einen Gleichstrommotor 5 angeordnet. Das Netzteil 2, die Endstufe 3 und die Ansteuerlogik 4 sind für Niederspannung, d. h. für eine Spannung von 110 V bis 240 V ausgelegt. Über elektrische Leiter 7 liegt der Gleichstrommotor 5 an die Endstufe 3 an, die über weitere Leiter 8 mit dem Netzteil 2 in Verbindung steht. Außerdem ist das Netzteil 2 über Leiter 9 mit der Ansteuerlogik 4 in Verbindung gebracht, während die Ansteuerlogik 4 über Leiter 10 mit der Endstufe 3 verbunden ist. Mit 11 ist ein Schalter zur Drehrichtungsänderung des Motors 5, mit 12 ein Schalter für Start und Stop bezeichnet, während der Drehwiderstand 13 die Drehzahl des Elektromotors zu ändern vermag.

Außerdem steht über Leiter 14 die Ansteuerlogik 4 mit einer Rotorlage-Erkennung 15 in Verbindung.

## Ansprüche

1. Gleichstrommotor mit elektronischer Kommutierung zum Betrieb mit Wechselstrom und einer Ansteuerlogik, dadurch gekennzeichnet, daß ein Netzteil, eine Endstufe und eine Ansteuerlogik ausgelegt für 110 bis 240 Volt Wechselspannung vorgesehen sind und daß der Netzteil, die Endstufe und die Ansteuerlogik gemeinsam auf einer einzigen Leiterplatte angeordnet sind.

2. Gleichstrommotor nach Anspruch 1, dadurch gekennzeichnet, daß die Leiterplatte die maximale Größe von 160 x 100 mm aufweist (Europaplatte).

3. Gleichstrommotor nach Anspruch 1, dadurch gekennzeichnet, daß die Wechselspannung eine Frequenz von 47 bis 63 Hz aufweist.

4. Gleichstrommotor nach Anspruch 1, dadurch gekennzeichnet, daß in der Endstufe ausschließlich N-Kanal MOS-FET Transistoren für 500 Volt angeordnet sind.